# EUROPEAN PATENT APPLICATION

(11) **EP 2 216 801 A2**
(43) Date of publication of application: **11.08.2010**
(21) Application number: 10152697.8
(22) Date of filing: 04.02.2010
(51) Int. Cl.: H01L 21/02, H01L 23/66, H01L 25/07, H01L 31/02, H01L 31/058, H02J 7/00, H01G 4/008

(54) **An electrical device having a power source with a magnetic capacitor as an energy storage device**

(30) Priority: 05.02.2009 US 366264
(71) Applicant: Northern Lights Semiconductor Corp., Saint Paul, MN 55113 (US)
(72) Inventor: Lai, James Chyi, Saint Paul, MN 55113 (US); Fong, Kai Chun, Saint Paul, MN 55113 (US)
(74) Representative: Mertens, Hans Victor

(57) **Abstract**

The present invention discloses an electrical device. The electrical device comprises an integrated circuit chip with a positive terminal and a negative terminal, wherein the integrated circuit chip has an energy management function; and a magnetic capacitor connecting with the integrated circuit chip, the magnetic capacitor (100) stores electrical power and provides the electrical power to the integrated circuit chip, wherein the magnetic capacitor comprises: a first magnetic section (110) connects with the positive terminal; a second magnetic section (120) connects with the negative terminal; and a dielectric section (130) configured between the first magnetic section and the second magnetic section; wherein the dielectric section is arranged to store the electrical power.

## Description

The present invention relates to an electrical device. More particularly, the present invention relates to an electrical device having a power source using a magnetic capacitor as an energy storage device.

Thin-film batteries are a power source for providing power to a system. A thin-film battery provides a constant voltage to the electronic device so that the electronic device may be powered by a stable power source. However, the use of thin-film batteries as power sources for electronic devices suffer from a couple of problems. First, existing thin-film batteries are big and place constraints on the flexing characteristics of the card. Second, existing thin-film batteries do not have sufficient power to support a broader range of operations. Third, thin-film primary batteries have limited operating and shelf life. Fourth, time required for recharging a thin-film rechargeable battery is long.

For the forgoing reasons, there is a need for a new type of power source, so that it has low energy transport costs, and can be an alternative to a battery while overcoming the problems stated above.

The present invention is directed to an electrical device having a power source using a magnetic capacitor as an energy storage device.

The present invention discloses an electrical device. The electrical device comprises an integrated circuit chip with a positive terminal and a negative terminal, wherein the integrated circuit chip has an energy management function; and a magnetic capacitor connecting with the integrated circuit chip, the magnetic capacitor stores electrical power and provides the electrical power to the integrated circuit chip, wherein the magnetic capacitor comprises: a first magnetic section connected with the positive terminal; a second magnetic section connected with the negative terminal; and a dielectric section configured between the first magnetic section and the second magnetic section; wherein the dielectric section is arranged to store the electrical power.

It is to be understood that both the foregoing general description and the following detailed description are by examples, and are intended to provide further explanation of the invention as claimed.

The accompanying drawings are included to provide a further understanding of the invention, and are incorporated in and constitute a part of this specification. The drawings illustrate embodiments of the invention and, together with the description, serve to explain the principles of the invention. In the drawings:
Fig. 1 shows a schematic diagram of a magnetic capacitor according to the present invention.
Fig. 2 shows the apparatus when the apparatus is charging according to an embodiment of the invention.
Fig. 3 illustrates a side cross-sectional view of the magnetic capacitor that is charged by a solar panel.
Fig. 4 shows a magnetic capacitor in a powered smart card.
Fig. 5 shows a RFID reader and sensor device.
Fig. 6 shows a magnetic capacitor providing power to RF transmission.
Figs. 7 and Fig. 8 show a package structure that includes a magnetic capacitor for providing power to integrated circuits (ICs) chip.

Reference will now be made in detail to the present preferred embodiments of the invention, examples of which are illustrated in the accompanying drawings. Wherever possible, the same reference numbers are used in the drawings and the description to refer to the same or like parts.

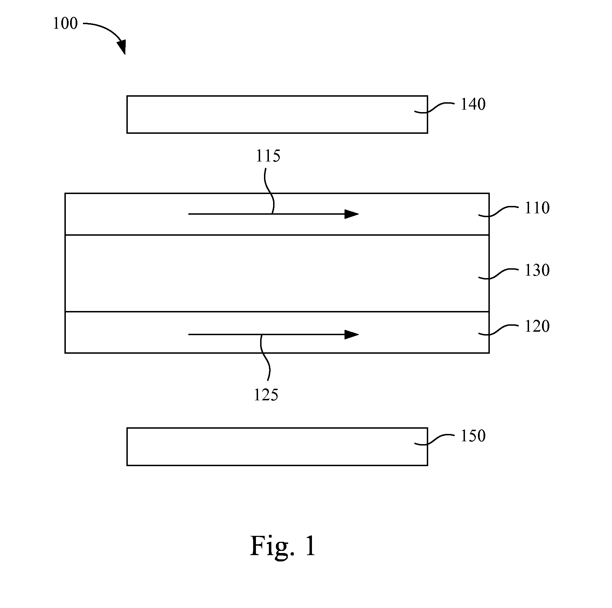

Fig. 1 shows a schematic diagram of a magnetic capacitor according to the present invention. It is noticed that other types of the magnetic capacitor can be used in the present invention. The magnetic capacitor 100 has a first magnetic section 110, a second magnetic section 120, and a dielectric section 130 configured between the first magnetic section 110 and the second magnetic section 120. The dielectric section 130 is arranged to store electrical energy, and the first magnetic section 110 and the second magnetic section 120 with dipoles (such as 115 and 125) are arranged to prevent electrical energy leakage. The dielectric section 130 is a thin film, and the dielectric section 130 is composed of dielectric material, such as BaTiO₃ or TiO₃.

The apparatus further has a first metal device 140 disposed around the first magnetic section 110, wherein the first metal device 140 is arranged to control the dipole 115 of the first magnetic section 110. The apparatus also has a second metal device 150 disposed around the second magnetic section 120, wherein the second metal device 150 is arranged to control the dipole 125 of the second magnetic section 120. The designer or user can use the first metal device 140 and the second metal device 150 to apply external fields to control the dipoles of the magnetic sections 110 and 120.

When the apparatus stores electrical energy, the dipoles 115 (→) and 125 (→) of the first magnetic section 110 and the second magnetic section 120 are the same, the first magnetic section 110 and the second magnetic section 120 prevent electrical energy leakage, and electrical energy can be stored in the dielectric section 130. When the dipoles 115 and 125 of the first magnetic section 110 and the second magnetic section 120 are opposite, the electrical energy stored in the dielectric section 130 can be released.

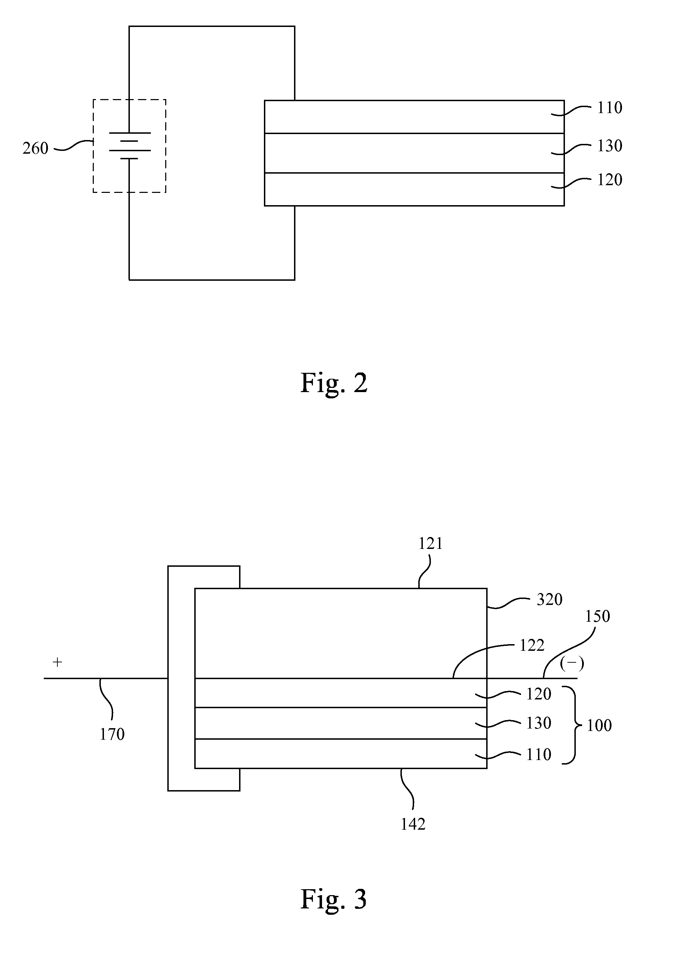

Fig. 2 shows the apparatus when the apparatus is charging according to an embodiment of the invention. When the apparatus is charged, the dipoles 115 and 125 of the first magnetic section 110 and the second magnetic section 120 are controlled to be opposite and the first magnetic section 110 and the second magnetic section 120 are coupled to a power source 260. The electrical energy can be inputted into the dielectric section 130 from the power source 260. Then, the dipoles 115 and 125 of the first magnetic section 110 and the second magnetic section 120 are controlled to be same to store the inputted electrical energy.

In another embodiment, the magnetic capacitor is charged by a solar power source. Fig 3 illustrates a side cross-sectional view of the magnetic capacitor that is charged by a solar panel. The solar panel 320 receives solar energy from sunlight, and the magnetic capacitor 100 stores the solar energy. The solar panel 320 has a first side 121 and a second side 122. The first side 121 of the solar panel 320 faces the sun, and the second magnetic section 120 of the magnetic capacitor 100 is attached to the second side 122 of the solar panel 320. The first magnetic section 110 of the magnetic capacitor 100 is away from the sunlight. A first wire 150 is placed between the second side 122 of the solar panel 320 and the second magnetic section 120 of the magnetic capacitor 100. A second wire 170 is attached to the first side 121 of the solar panel 320 and the first magnetic section 110 of the magnetic capacitor 100. The end of the first wire 150 can be an anode, while the end of the second wire 170 can be a cathode.

A method of manufacturing the magnetic capacitor that is charged by a solar panel includes the following steps: forming the solar panel 320 having a first side 121 and a second side 122; forming the magnetic capacitor 100 having a first magnetic section 110, a second magnetic section 120, and a dielectric section 130; joining the solar panel 320 and the magnetic capacitor 100 by abutment; placing a first wire 150 in between the second side 122 of the solar panel 320 and the second magnetic section 120 of the magnetic capacitor 100; and attaching a second wire 170 to the first side 121 of the solar panel 320 and the first magnetic section 110 of the magnetic capacitor 100. The end of the first wire 150 forms an anode, while the end of the second wire 170 forms a cathode. The solar panel 320 and the magnetic capacitor 100 are both manufactured on semiconductor manufacturing equipment. The solar panel 320 is formed with a high temperature, whereas the magnetic capacitor 100 is formed with a lower temperature. The solar panel 320 and the magnetic capacitor 100 are manufactured separately, so the yields would be higher. With metal on the second side 122 of the solar panel 320, and metal on the second magnetic section 120 of the magnetic capacitor 100, it is easy to connect both.

The magnetic capacitor 100 that stores electrical energy can be used to provide power to integrated circuits (ICs), RF transmission, and Ultra Low Power Electronics Systems such as Smart Cards, RFIDs, and Sensors.

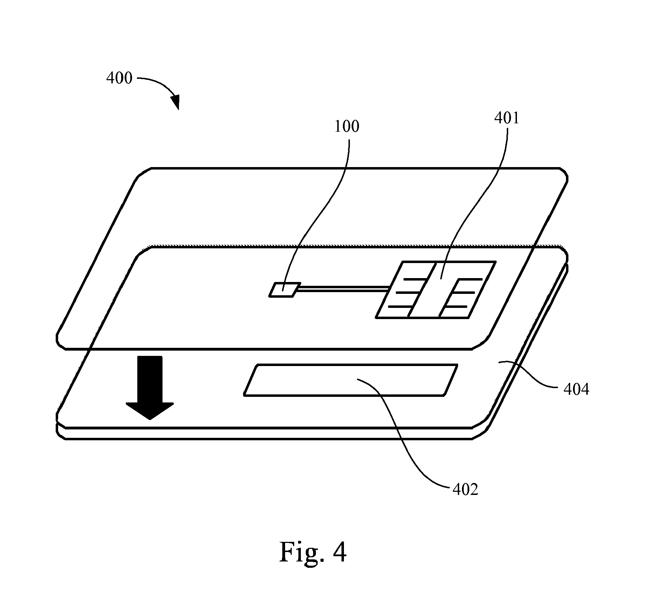

Fig. 4 shows a magnetic capacitor in a powered smart card. The powered smart card 400 includes a card substrate 404, an IC chip 401 and a display 402 both formed on the card substrate 404. The IC chip 401 can perform both calculations and memory functions. For example, in an embodiment, the smart card 400 can generate a one-time password. The IC chip 401 can process a program to generate the one-time password. The magnetic capacitor 100 is connected to the IC chip 401 to provide power to the IC chip 401 to perform calculations. In an embodiment, the first magnetic section 110 and the second magnetic section 120 are connected to the positive terminal and the negative terminal of the IC chip 401 respectively. The display 402 can show the calculations result, such as the one time password. In another embodiment, the smart card 400 uses a biometric sensor to detect the user to improve security. The power for the biometric sensor is provided by the magnetic capacitor 100.

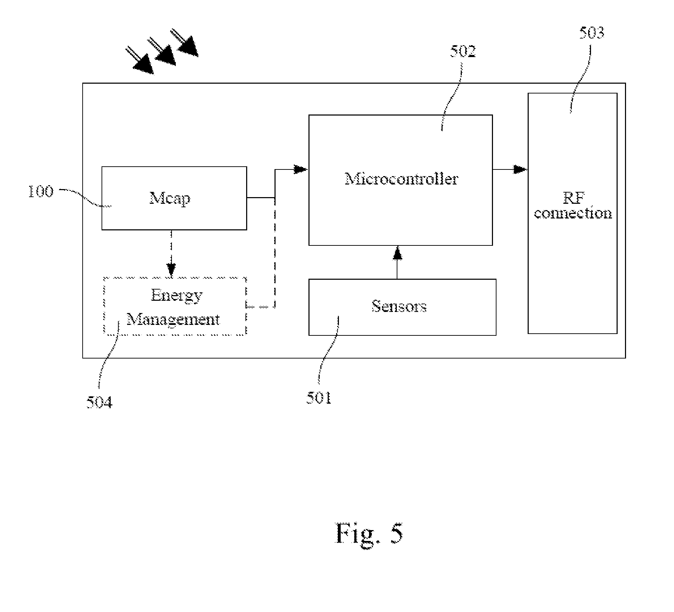

Fig. 5 shows a RFID reader and sensor device. The device is a PDA-like battery-driven mobile device. The device includes a physical sensor 501 for sensing temperature, pressure, speed, etc., a low-power microcontroller 502, and a low-power, small-range wireless radio frequency connection 503. In this embodiment, the magnetic capacitor 100 is the power source to provide power to the microcontroller 502. In an embodiment, the first magnetic section 110 and the second magnetic section 120 are connected to the positive terminal and the negative terminal of the microcontroller 502 respectively. For stable supplying power to the microcontroller 502, a solar panel 320 is used to charge the magnetic capacitor 100. The structure of the solar panel 320 and the magnetic capacitor 100 is illustrated in the Fig. 3. Furthermore, an energy management unit 504 manages the power supplied to the microcontroller 502.

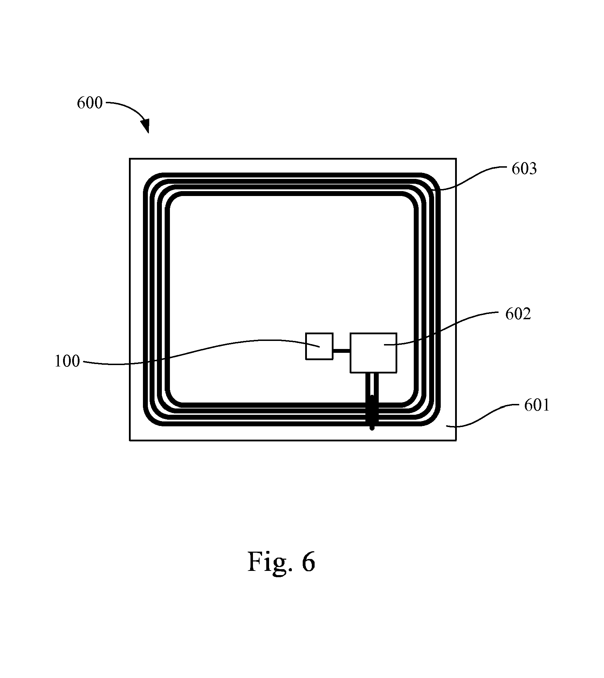

Fig. 6 shows a magnetic capacitor providing power to RF transmission. The RF transmission 600 includes a tag substrate 601, an antenna 603 formed on the tag substrate 601 and an RFID ASIC 602 surrounded by the antenna 603. A magnetic capacitor 100 is connected to the RFID ASIC 602 for supplying power to the RFID ASIC 602. In an embodiment, the first magnetic section 110 and the second magnetic section 120 are connected to the positive terminal and the negative terminal of the RFID ASIC 602 respectively. Because the RF transmission 600 has a power source, and the magnetic capacitor 100, the RF transmission 600 is an active RFID tags that can transmit in longer distances.

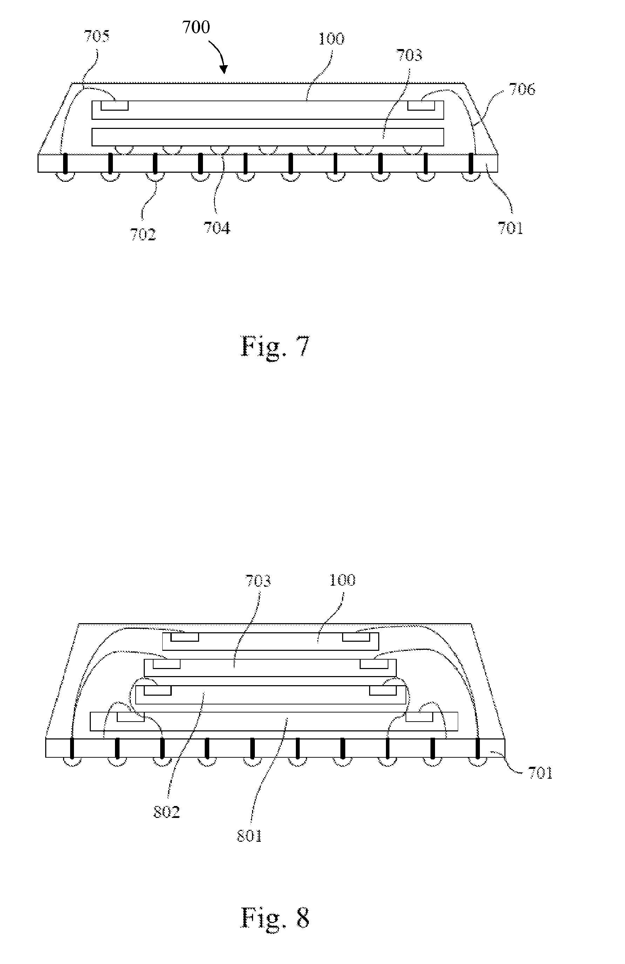

Fig. 7 and Fig. 8 show a package structure that includes a magnetic capacitor for providing power to integrated circuits (ICs) chip. The package structure 700 includes a substrate 701 with a plurality of solder balls 702. An integrated circuits (ICs) chip 703 with power management is formed over the substrate 701 and includes a plurality of solder ball 704 to connect with the substrate 701. A magnetic capacitor 100 is formed over the integrated circuits (ICs) chip 703. A lead wire 705 connects the positive terminal of the magnetic capacitor 100 with the substrate 701. A lead wire 706 connects the negative terminal of the magnetic capacitor 100 with the substrate 701. Then, a package material is added around the integrated circuits (ICs) chip 703 and the magnetic capacitor 100 to form the package structure 700 to incorporate with a circuit.

Furthermore, in another embodiment, the package structure 700 can contain several chips, such as a specialized processor 801, DRAM or flash memory 802, all mounted on the same substrate as shown in the Fig. 8. This means that a complete functional unit can be built in a multi-chip package, so that few external components need to be added to make it work. This is particularly valuable in space constrained environments, like MP3 players and mobile phones, as it reduces the complexity of the printed circuit board and overall design.

The invention at least includes these advantages:
1.This invention reduces the amount of time required to recharge the power source for the system.
2.This invention reduces the weight of the system.
3.This invention reduces the size of the system (in systems where battery size is the determining factor).
4.This invention does not affect the flexing characteristics of the system.
5.This invention increases the onboard processing capabilities of the system.
6.This invention increases the communication range of the system.
7.This device does not share the memory problem with batteries, in that it can be fully or partially discharged between each recharging without loss of performance.
8.This device has a much higher number of re-chargings compared to batteries.
9.This device has a longer shelf life compared to thin-film primary batteries.
10.This device provides a higher amount of energy to the system, reducing limitations for a portable system.
11.This device provides for a longer period of operation than traditional systems.
12.This device provides an unlimited number of recharge cycles without loss or degradation of performance.
13.This device can be manufactured at a much reduced cost compared to thin-film batteries.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. An electrical device, comprising:
an integrated circuit chip with a positive terminal and a negative terminal, wherein the integrated circuit chip has an energy management function; and
a magnetic capacitor connecting with the integrated circuit chip, the magnetic capacitor stores electrical power and provides the electrical power to the integrated circuit chip, wherein the magnetic capacitor comprising:
a first magnetic section connects with the positive terminal;
a second magnetic section connects with the negative terminal; and
a dielectric section configured between the first magnetic section and the second magnetic section;
wherein the dielectric section is arranged to store the electrical power.

2. The electrical device of claim 1, further comprising a solar panel, wherein the solar panel has a first side and a second side, the first side receives solar energy from sunlight and the second magnetic section is attached to the second side, wherein a first wire is placed between the second side and the second magnetic section and a second wire is attached to the first side and the first magnetic section.

3. The electrical device of claim 1, wherein end of the first wire is an anode and end of the second wire is a cathode.

4. The electrical device of claim 1, wherein the electrical device is a smart card and the integrated circuit chip is the smart card integrated circuit.

5. The electrical device of claim 1, wherein the electrical device is a RF transmission and the integrated circuit chip is a RFID ASIC, wherein a tag substrate, an antenna formed on the tag substrate and the RFID ASIC surrounded by the antenna.

6. The electrical device of claim 1, wherein the electrical device is a sensor device and the integrated circuit chip is a microcontroller, wherein a sensor connected with the microcontroller and wireless radio frequency connection connected with the microcontroller.

7. The electrical device of claim 1, wherein the electrical device is a packed electrical device and the packed electrical device comprises a substrate with a plurality of solder ball, at least one the integrated circuit chip formed over the substrate and the magnetic capacitor formed over the integrated circuit chip, wherein the integrated circuit chip is a specialized processor, DRAM or flash memory.

8. An electrical device, comprising:
an integrated circuit chip with a positive terminal and a negative terminal, wherein the integrated circuit chip has an energy management function;
a magnetic capacitor connecting with the integrated circuit chip, the magnetic capacitor stores electrical power and provides the electrical power to the integrated circuit chip, wherein the magnetic capacitor comprises:
a first magnetic section;
a second magnetic section;
a dielectric section configured between the first magnetic section and the second magnetic section; and
a solar panel, wherein the solar panel has a first side and a second side, the first side receives solar energy from sunlight and the second magnetic section is attached to the second side;
wherein the dielectric section is arranged to store the electrical power.

9. The electrical device of claim 8, further comprising a first wire is placed between the second side and the second magnetic section and a second wire is attached to the first side and the first magnetic section, wherein end of the first wire is connected to the positive terminal and end of the second wire is connected to the negative terminal.

10. The electrical device of claim 8, wherein the electrical device is a smart card and the integrated circuit chip is the smart card integrated circuit.

11. The electrical device of claim 8, wherein the electrical device is a RF transmission and the integrated circuit chip is a RFID ASIC.

12. The electrical device of claim 11, further comprising a tag substrate, an antenna formed on the tag substrate and the RFID ASIC surrounded by the antenna.

13. The electrical device of claim 8, wherein the electrical device is a sensor device and the integrated circuit chip is a microcontroller.

14. The electrical device of claim 13, further comprising a sensor connected with the microcontroller and wireless radio frequency connection connected with the microcontroller.

15. The electrical device of claim 8, wherein the electrical device is a packed electrical device and the packed electrical device comprises a substrate with a plurality of solder ball, at least one the integrated circuit chip formed over the substrate and the magnetic capacitor formed over the integrated circuit chip.
